# EUROPEAN PATENT APPLICATION

(11) **EP 1 684 348 A2**
(43) Date of publication of application: **26.07.2006**
(21) Application number: 06001285.3
(22) Date of filing: 21.01.2006
(51) Int. Cl.: H01L 25/10

(54) **Improved stack chip package**

(30) Priority: 21.01.2005 CN 200520001336
(71) Applicant: Tzu, Chung-Hsing, Rugo 226500 Jiansu Province (CN)
(72) Inventor: Tzu, Chung-Hsing, Rugo 226500 Jiansu Province (CN)
(74) Representative: Bucher, Ralf Christian

(57) **Abstract**

The invention relates to an improved stack chip package which comprises a lead frame (1), a chip (2), plural leads (3) and coating (4), wherein
the lead frame (1) comprises plural pins (11) in rows,
each pin (11) comprises three segments, i.e. a first lead segment (111), a second lead segment (112) and a connecting part (113) connected to the first and second lead segment,
the improved stack chip package is made by installing the chip (2) on the inside surface of the first lead segment (111) of each pin (11) of the lead frame (1) and fixing it, bonding a conductive wire at the bond pads of the chip and each segment of pins respectively to form an electrical connection, coating the part around the chip (2) where the lead is jointed to complete the sealing operation and to have the first and second lead segment (111, 112) and the connecting part (113) jutted on the both surfaces and sides of the chip (2), and then the obtained plural chip package can be stacked through each pin of the lead frame.

## Description

### FIELD OF THE PRESENT INVENTION

The present invention provides a kind of an improved stack chip package, particularly a kind of an improved structure of a chip package that can be cascaded at will.

### BACKGROUND OF THE PRESENT INVENTION

Nowadays, many electric products such as a mobile phone, a MP3 Walkman, a portable disc, a digital camera, a Personal Digital Assistant (PDA), are more delicate and multipurpose, which may be used for digital photography, recording, data storage etc., besides their main functions. Therefore an improved functional chip package for the application of such functions is required, so that the electric product would be small in size and of good efficiency in multifunction.

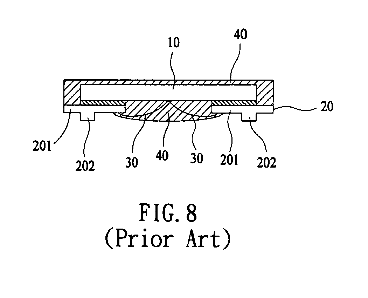

A prior art chip package (as shown in Figure 8) consists of a chip 10, a lead frame 20, plural leads 30 and a coating 40. Usually such a package makes the lead frame 20 form two or four rectangular pins 201 side by side. Or a convex block 202 was designed at the end of rectangular pins 201 for external electric conduction. Thereby installing the chip 10 on the lead frame 20, and forming an insulating coating on the lead 30 area for sealing after bonding the lead 30 on the chip10 with the inside end of the pin 201 for an electrical connection, the chip package is obtained by means of connecting the plural pins 201 of the lead frame 20 with the circuit boards of electrical devices.

The abovementioned prior art chip package must be connected to the circuit board of an electronic product with the lead frame 20. When installing the plural chip package on a circuit board, it must be connected side by side. Especially when electronic products are required to have a small size and various functions as the abovementioned ones, such an installation certainly will increase the numbers of paralleled chips and further make electronic products not to be a simple structure or have limited functions. In such case, it would lag behind the trends in this field.

### SUMMARY OF THE PRESENT INVENTION

A primary purpose of the present invention is to provide an improved cascade chip package.

The present invention relates to an improved stack chip package with features as specified in claim 1. Preferred embodiments of the invention are subject of the dependent claims.

Based on the improvement in pins and chip-fixing position, a plural chip package can be cascaded with more free space and strengthened data processing performance.

As the abovementioned purposes, the present invention comprises a lead frame, a chip, plural leads and coating, among which: the lead frame may be made of metal materials by means of impact stamping or etching forming two or four lines of rectangular plural pins. Each pin comprises three segments, i.e. a first lead segment, a second lead segment and a connecting part connected to the first and second lead segment, making the pin ⊏-shaped; the chip is an electronic component made of semiconductor materials; the lead may be a metal conductor and the coating epoxy may be made from a nonconductive material. So installing a chip on the inside surface of the first wire segment of the lead frame, bonding conductive wires at the bond pad of the chip and each lead segment on one side to form an electrical connection, coating the part around the chip where the lead is jointed for the completion of sealing operation, i.e. the upper and lower sides of the chip can be connected to another chip package by the contact of the first and second lead segments, the chip package can be stacked at will, besides its reduced volume and strengthened data processing performance.

### BRIEF DESCRIPTION OF THE DRAWINGS

Figure 1-A is a cutaway view I of the present invention;
Figure 1-B is a cutaway view II of the present invention;
Figure 2 is a three-dimensional diagram of the present invention;
Figure 3 is a sketch map of pins of the lead frame of the present invention;
Figure 4 is a sketch map of pins in twin-row package of the present invention;
Figure 5 is a sketch map of pins in matrix package of the present invention;
Figure 6 is a sketch map of a chip package in side by side connection of the present invention;
Figure 7 is a cutaway view of another embodiment of the present invention; and
Figure 8 is a cutaway view of a prior art chip package.

### METHODS OF APPLICATION

The embodiment presents the structural characteristics, functions and purposes of the present invention with drawings as follows:

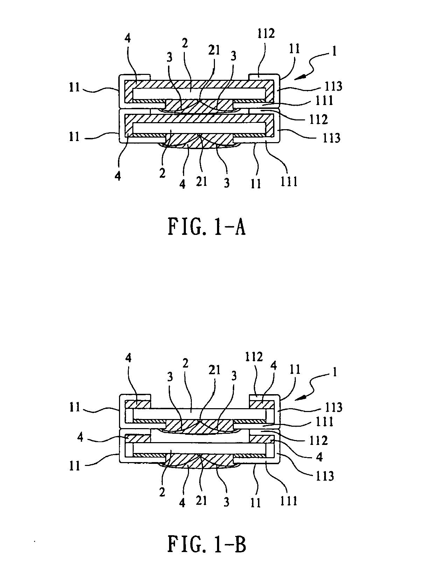

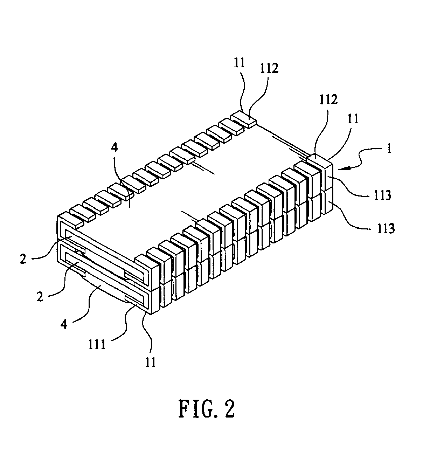

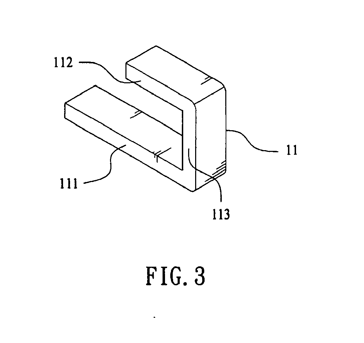

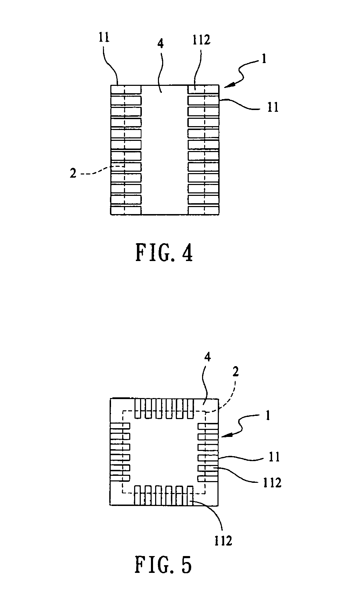

As shown in Figure 1-A, 1-B and 2, the present invention provides a kind of improved cascade chip package, comprising a lead frame 1, a chip 2, plural leads 3 and coating 4, among which: the lead frame 1 is made of metal materials by means of impact extrusion or etching forming two lines in parallel (as shown in Figure 4) or four lines of matrix plural pins 11 (as shown in Figure 5). Each pin 11 comprises three segments, i.e. a first lead segment 111, a second lead segment 112 and a connecting part 113 connected to the first and second lead segment (as shown in Figure 3), making the pin C-shaped;
the chip 2, as shown in Figure 1-A and 1-B, is an electronic component made of semiconductor materials. And a plural electrical connection contact 21 was set on the selected surface;
the lead 3 is the metal conductor, which may be a wire etc.; and
the coating 4 is an insulating nonconductive compound material for sealing the chip package 2.

Thereby, as shown in Figure 1-A and 1-B, installing a chip 2 on the inside surface of the first lead segment 111 of the lead frame 1, mounting leads 3 at the contact of the chip 2 and each lead segment 111 on one side to form an electrical connection, coating the part around the chip 2 where the lead is jointed in order to complete sealing operation, i.e. make the first and second lead segments 111,112 and connecting part 113 bare on the chip 2 and the two surfaces and sides of the coating 4, then the obtained plural chips 2 can be stacked and continued through each pin 11 of the lead frame 1 (as shown in Figure 2).

Because the upper and lower sides of the chip 2 have an exposed jutted pin 11 comprising the first and second lead segment 111, 112, the plural chip package can be stacked at will by manufacturers and installed onto the electric boards of electronic products to obtain more free space, exert functions to the utmost, such as abovementioned digital photography, recording, data storage and so on, and strengthened data processing performance.

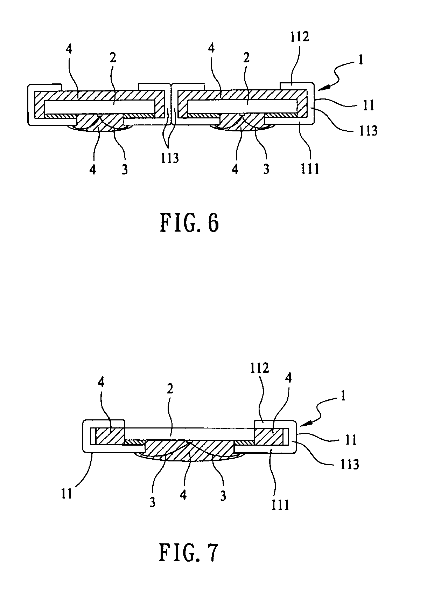

In addition, in this invention, the connecting part 113 of each pin 11 of the lead frame 1 has been jutted on two sides of the chip 2 and the coating 4. In case of side by side design requirement, the improved chips can be contacted with each other on the connecting part 113 based on proper circuit design for forming an electrical connection (as shown in Figure 6) and to further free more space from circuit boards and ensure the demands for small size and multifunction upon the electronic products at present and in the future.

Furthermore, as shown in Figure 7, the coating 4 is not designed to seal the chip 2 absolutely and it can be installed onto the two sides of the chip 2 to make the top of the chip 2 hollowed and further to shorten the distance between the first and second wire segment 111, 112 of each pin 11 of the lead frame 1 and to provide a smaller and thinner chip package for the application of electronic products.

In summary, this improved stack chip package is innovative and practical. Its methods of application are also original and its functions conform to its design purpose.

### BRIEF DESCRIPTION OF THE REFERENCE NUMERALS

Lead Frame 1
Chip 2
Lead 3
Coating 4
Pins 11
Contact 21
First lead segment 111
Second lead segment 112
Connecting part 113

## Claims

1. An improved stack chip package comprises a lead frame (1), a chip (2), plural leads (3) and coating (4), wherein
the lead frame (1) comprises plural pins (11) in rows,
each pin (11) comprises three segments, i.e. a first lead segment (111), a second lead segment (112) and a connecting part (113) connected to the first and second lead segment,
the improved stack chip package is made by installing the chip (2) on the inside surface of the first lead segment (111) of each pin (11) of the lead frame (1) and fixing it, bonding a conductive wire at the bond pads of the chip and each segment of pins respectively to form an electrical connection, coating the part around the chip (2) where the lead is jointed to complete the sealing operation and to have the first and second lead segment (111, 112) and the connecting part (113) jutted on the both surfaces and sides of the chip (2), and then the obtained plural chip package can be stacked through each pin of the lead frame.

2. The improved stack chip package as claimed in claim 1, wherein the plural pins include two types, twin-row parallel and four-row matrix.

3. The improved stack chip package as claimed in claim 1 or 2, wherein the coating includes the sealing part around the chip.

4. The improved stack chip package as claimed in claim 1 or 2, wherein the coating includes the hollowed part of the chip that is formed with sealing part on the one side of the chip.

5. The improved stack chip package as claimed in claim 1 or 2, wherein the chip package includes the connecting part where the chip can be connected to another chip package.
